Europäisches Patentamt

European Patent Office

Office européen des brevets

(19)

(11) Numéro de publication: **0 597 014 B1**

(12)

# FASCICULE DE BREVET EUROPEEN

(45) Date de publication du fascicule du brevet: **11.10.95**   (51) Int. Cl.⁶: **B63G 9/06**

(21) Numéro de dépôt: **92917138.7**

(22) Date de dépôt: **21.07.92**

(86) Numéro de dépôt internationale :
**PCT/FR92/00714**

(87) Numéro de publication internationale :
**WO 93/01971 (04.02.93 93/04)**

(54) **STATION PORTABLE DE MESURE ET DE REGLAGE DE LA SIGNATURE MAGNETIOUE D'UN BATIMENT NAVAL.**

(30) Priorité: **23.07.91 FR 9109277**

(43) Date de publication de la demande:
**18.05.94 Bulletin 94/20**

(45) Mention de la délivrance du brevet:
**11.10.95 Bulletin 95/41**

(84) Etats contractants désignés:
**DE GB IT**

(56) Documents cités:
**EP-A- 0 133 408**
**EP-A- 0 247 367**
**WO-A-87/02324**
**GB-A- 2 177 511**
**US-A- 4 710 708**

(73) Titulaire: **THOMSON-CSF**
**173, Boulevard Haussmann**
**F-75008 Paris (FR)**

(72) Inventeur: **CERTENAIS, Joel**
**Thompson-CSF SCPI**
**F-92045 Paris-La Défense Cédex 67 (FR)**

(74) Mandataire: **Desperrier, Jean-Louis et al**
**THOMSON-CSF**
**SCPI**
**B.P. 329**
**50, rue Jean-Pierre Timbaud**
**F-92402 Courbevoie Cédex (FR)**

## Description

L'invention concerne une station portable de mesure et de réglage de la signature magnétique d'un bâtiment naval permettant de déterminer et/ou de modifier les caractéristiques des courants circulant dans les boucles d'immunisation magnétique dont est pourvu ce bâtiment naval.

Il est connu que la présence de matériaux ferromagnétiques dans un bâtiment naval rend celui-ci détectable par des moyens de détection de sa "signature magnétique". Ces moyens de détection peuvent par exemple être intégrés dans des mines ou être portés par des aéronefs. Dans ce dernier cas, le risque associé à la détection de la signature magnétique du bâtiment naval est appelé risque M.A.D. (Magnetic Anomaly Detection).

La signature magnétique d'un bâtiment est constituée par son aimantation permanente et par son aimantation induite. L'aimantation permanente est due aux matériaux ferromagnétiques entrant dans la constitution du bâtiment et est sensiblement constante. Par contre, l'aimantation induite est essentiellement variable et, dans le cas d'un navire, dépend de son orientation dans le champ magnétique terrestre, de son cap et de son inclinaison due au roulis et au tangage.

La signature magnétique du navire permet donc de le repérer, de le suivre, et éventuellement de guider ou de mettre à feu des engins destinés à le détruire. Il est donc très important de minimiser, voire d'annuler cette signature magnétique pour empêcher sa détection par un méthode magnétique.

Cette opération d'immunisation magnétique s'effectue en créant dans le volume du bâtiment un champ magnétique qui compense celui du bâtiment, afin d'annuler sa signature magnétique. Pour cela, on munit le bâtiment d'un jeu de circuits appelés boucles d'immunisation, qui sont parcourus par un courant électrique.

Les dimensions, la disposition des boucles et les courants qui y circulent sont déterminés pour minimiser au mieux la "signature magnétique" du bâtiment, quelle que soit son orientation dans le champ magnétique terrestre, c'est-à-dire quels que soient son cap et son inclinaison due au roulis et au tangage. Ces boucles d'immunisation sont réparties suivant trois directions correspondants aux axes de roulis, de lacet et de tangage.

Le réglage des courants dans les boucles d'immunisation est effectué grâce à une station de mesures. Classiquement, les stations de mesures sont constituées par deux réseaux linéaires de capteurs magnétiques disposés au fond de la mer et installés par exemple l'un selon une direction Nord-Sud, et l'autre selon une direction Est-Ouest. Ces réseaux de capteurs magnétiques sont reliés par câbles à une station installée à terre qui analyse les mesures effectuées afin de déterminer les caractéristiques des courants à faire circuler dans les différentes boucles.

L'aimantation totale (permanente + induite) s'écrit :

$$PL + PV + PT + IV + IL\cos\alpha + IT\sin\alpha$$

où :
P est l'aimantation permanente,
I est l'aimantation induite,
L, V et T sont les trois axes suivant lesquels sont disposées les boucles d'immunisation,
$\alpha$ représente le cap magnétique du navire.

Ces différentes composantes de l'aimantation permanente et de l'aimantation induite d'un bâtiment naval sont effectuées grâce à une telle station de mesures en faisant parcourir au bâtiment naval deux fois le même trajet au-dessus des réseaux de capteurs magnétiques, selon des caps opposés.

L'aimantation permanente, liée au bâtiment, évolue avec le mouvement de celui-ci, alors que l'aimantation induite n'évolue pas. Pour connaître l'aimantation induite, il suffit de soustraire les résultats de mesure des deux sens opposés. Connaissant alors l'aimantation induite et l'aimantation totale, on obtient directement l'aimantation permanente. Ainsi, un passage Nord-Sud puis Sud-Nord permet de déterminer IL et un passage Est-Ouest puis Ouest-Est permet de calculer IT.

Cependant, cette méthode de mesure ne permet pas de déterminer IV.

En effet, l'aimantation induite verticale ne peut pas être déterminée à partir de mesures effectuées à une seule latitude. Cette composante est en effet fonction de la variation de la composante verticale du champ magnétique terrestre. Les stations de mesure de l'aimantation des bâtiments navals n'étant pas disponibles à toutes les latitudes, la détermination de l'aimantation induite verticale est alors réalisée en mettant en oeuvre des méthodes empiriques. Une de ces méthodes, utilisée dans la plupart des cas, consiste à considérer que l'aimantation induite verticale représente un certain pourcentage fixe de l'aimantation totale verticale mesurée dans un lieu donné. Cependant ces méthodes empiriques ne permettent pas de déterminer l'aimantation induite verticale de façon précise ce qui a pour conséquence de diminuer la qualité de la compensation magnétique calculée à partir des différentes composantes de l'aimantation du bâtiment.

Par ailleurs, lors d'une opération de longue durée, la signature magnétique d'un bâtiment naval se dégrade dans le temps. Cette dégradation est due notamment aux vibrations permanentes auxquelles est soumis le bâtiment naval, par rapport au champ magnétique terrestre. Les caractéristiques des courants électriques circulant dans les boucles d'immunisation qui ont été déterminés initialement par une station terrestre ne permettent plus, au bout d'un certain temps, de compenser de façon satisfaisante la signature magnétique du bâtiment naval. Il est donc nécessaire de pouvoir recalculer périodiquement la valeur des courants devant circuler dans les boucles d'immunisation.

Ces différents problèmes ont suscité l'apparition de stations de mesures magnétiques transportables qui peuvent être emportées à bord du navire, et permettent notamment de calculer les différentes composantes de l'aimantation magnétique d'un bâtiment naval selon sa position géographique, par exemple dans son port de départ, puis à son port d'arrivée, sous une autre latitude.

Bien entendu, ces stations transportables doivent comprendre non seulement une unité de mesure et de calcul embarqué, mais également un système de capteurs déployables autour du navire.

Les stations transportables de mesure de la signature magnétique des bâtiments navals les plus anciennes présentent un agencement identique aux stations fixes les unités terrestres étant simplement amovibles pour être transportables. Le coût de telles stations et de leur mise en oeuvre est évidemment élevé.

La demande de brevet GB 2 177 511 propose une station de mesures magnétiques transportable comportant un magnétomètre pouvant être posé sur le fond de la mer et relié à une bouée radio-électrique en surface transmettant au bâtiment naval les données recueillies par le magnétomètre. Ce magnétomètre triaxial est pendulé sur deux axes et est associé à un capteur de hauteur d'eau.

Les données sont acquises en déplaçant le bâtiment naval à proximité du magnétomètre à une vitesse constante, correspondant préférentiellement à la vitesse maximale du navire.

Les stations portables de ce type ne comportant qu'un capteur, la compensation magnétique associée est peu précise. En effet, ceci ne permet pas d'acquérir un nombre suffisant de paramètres pour affiner le calcul des différentes composantes de l'aimantation du bâtiment.

La qualité de la compensation magnétique ainsi effectuée est notablement inférieure à la qualité obtenue grâce aux stations de mesures terrestres.

L'invention se propose de pallier ces divers inconvénients de l'état de la technique.

Plus précisément, un objectif de la présente invention est de fournir une station portable de mesure de la signature magnétique d'un bâtiment naval permettant de fournir des résultats équivalents aux résultats obtenus grâce aux stations de mesures magnétiques terrestres fixes.

En particulier, un objectif de l'invention est de proposer une station portable de mesure et de réglage pouvant être rapidement déployée.

Un autre objectif de l'invention est de fournir une station portable pouvant être facilement et rapidement récupérée après sa mise en oeuvre.

Encore un autre objectif de l'invention est de proposer une station portable permettant non seulement de mesurer et de régler la signature magnétique du bâtiment naval mais pouvant également être éventuellement utilisée pour évaluer sa signature dépressionnaire et/ou sa signature acoustique.

Un autre objectif de l'invention est de proposer un procédé pour la mise en oeuvre d'une telle station portable

Pour cela, l'invention propose une station portable selon la revendication 1.

Selon un mode de réalisation particulièrement intéressant de la présente invention, les capteurs de hauteur d'eau sont constitués par des capteurs de pression. L'utilisation de capteurs de pression en guise de capteurs de hauteur d'eau présente l'intérêt de pouvoir fournir des paramètres pouvant également être utilisés pour évaluer la signature dépressionnaire du bâtiment.

Avantageusement le nombre de capteurs de hauteur d'eau est égal au nombre de capteurs magnétiques définis dans la revendication 1 et qui forment un chapelet déformable.

Préférentiellement les capteurs magnétiques sont disposés le long dudit chapelet selon un espacement régulier.

Egalement préférentiellement, ledit espacement entre deux capteurs correspond environ à la profondeur à laquelle ledit chapelet est susceptible d'être déposé.

Selon un mode de réalisation particulièrement intéressant, le chapelet est relié à une bouée de surface unique munie des moyens de transmission des données fournies par les capteurs magnétiques aux moyens de réception et d'analyse desdites données situés sur le bâtiment naval.

Préférentiellement, ledit chapelet est relié à ladite bouée par un câble muni de moyens de lestage, ledit chapelet étant raccordé audit câble en un point de raccordement situé au-dessus des moyens de lestage, des moyens de largage étant positionnés entre lesdits moyens de lestage et ledit point de raccordement. Cette disposition permet de pouvoir récupérer ledit chapelet sans avoir à remonter lesdits moyens de lestage.

De manière à faciliter encore la récupération dudit chapelet, lesdits moyens de largage sont télécommandables.

D'une façon préférentielle, lesdits moyens de largage télécommandables sont constitués par une manille explosive.

Bien que l'on puisse envisager de ne fixer que deux, trois ou quatre capteurs magnétiques le long dudit chapelet, le nombre de ces capteurs est avantageusement au moins égal à cinq. C'est en effet du nombre de paramètres acquis par les différents capteurs magnétiques que dépendra la qualité de la compensation magnétique du bâtiment naval.

Selon une variante complémentaire ledit chapelet comprend également des capteurs acoustiques. Cette dernière caractéristique permet d'obtenir une station combinée de la signature magnétique d'un bâtiment naval et de sa signature acoustique puisque lesdits capteurs acoustiques permettent d'obtenir des données concernant le bruit rayonné par la présence et/ou le déplacement dudit bâtiment naval.

Avantageusement, les capteurs placés à l'intérieur de la gaîne sont reliés à des câbles de reprise d'effort.

L'invention concerne également un procédé de mesure et de réglage de la signature magnétique d'un bâtiment naval, pour la mise en oeuvre de la station portable selon l'invention, selon la revendication 12.

D'une façon préférentielle, l'étape de ce procédé consistant à évaluer la déformée dudit chapelet consiste à :

- déterminer la déformée dudit chapelet dans le plan vertical en utilisant les données fournies par les capteurs de hauteur d'eau ;
- déterminer la déformée dudit chapelet dans le plan horizontal en utilisant une méthode d'interpolation mettant en oeuvre les coordonnées curvilignes Si des capteurs magnétiques d'une part et les angle $\theta i$ que ceux-ci forment avec le nord magnétique d'autre part.

Les coordonnées curvilignes Si des capteurs magnétiques correspondent à la distance existant entre les différents capteurs magnétiques sur le chapelet.

Avantageusement les angles $\theta i$ sont obtenus à partir des valeurs des composantes Hx, Hy du champ magnétique terrestre dans le plan horizontal selon la formule :

$$\theta i = \text{arctg} \frac{Hx}{Hy}$$

le bâtiment naval étant suffisamment éloigné dudit chapelet pour ne pas avoir d'influence sur les valeurs des composantes Hx et Hy.

Egalement préférentiellement l'étape consistant à déterminer le positionnement dudit bâtiment naval par rapport audit chapelet consiste à calculer, à partir des données z des capteurs de hauteurs d'eau, la dérivée seconde du champ magnétique :

$$\frac{\delta^2 Bz}{\delta z^2}$$

et à chercher la courbe de niveau

$$\frac{\delta^2 Bz}{\delta z^2} = 0$$

La détermination du positionnement du bâtiment naval par rapport au chapelet est ensuite affinée selon une méthode de "tracking". Cette étape peut-être effectuée par exemple à l'aide de moyens de visée optiques, acoustiques ou encore magnétiques. Préférentiellement cette étape est effectuée en munissant le bâtiment de réflecteurs laser, un système extérieur suivant à terre le positionnement de ces réflecteurs.

L'invention, ainsi que les différents avantages qu'elle présente seront plus facilement compris grâce à la description qui va suivre d'un exemple non limitatif de réalisation de l'invention en référence aux dessins dans lesquels :

- la figure 1 représente un bâtiment naval à proximité d'une station portable de mesure et de réglage de sa signature magnétique, ladite station étant déployée.
- la figure 2 représente une vue en coupe d'un magnétomètre triaxial pendulé pouvant être utilisé dans le cadre de la réalisation de la station portable selon l'invention.
- la figure 3 représente une vue schématique en élévation du chapelet de la station portable.

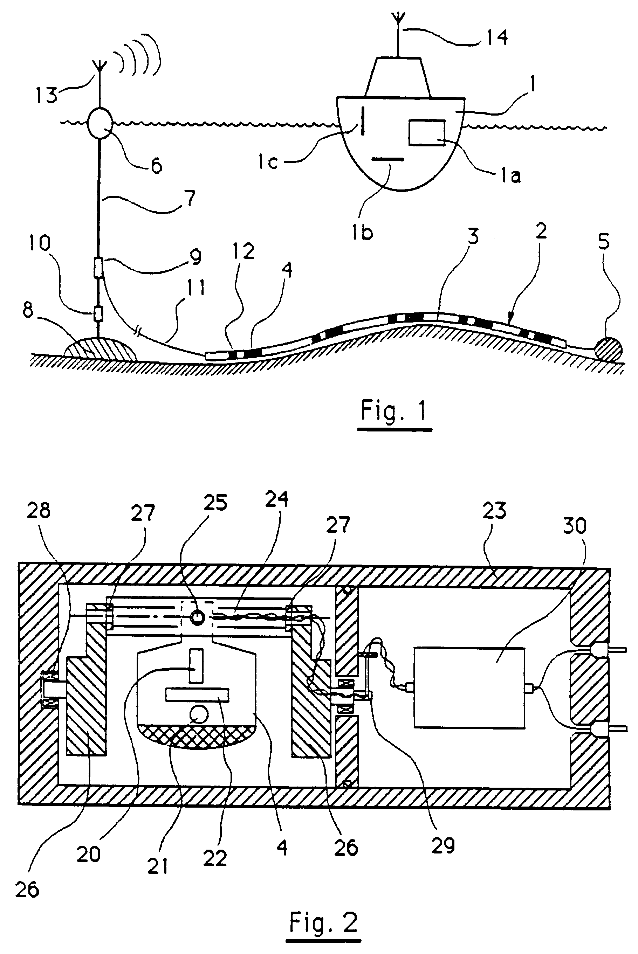

Selon la figure 1, un bâtiment naval 1 opère dans un environnement susceptible de présenter un risque de détection de sa signature magnétique. Le bâtiment naval présente plusieurs boucles d'immunisation magnétique 1a, 1b, 1c, disposées dans trois plans distincts. Certaines de ces boucles 1a sont destinées à compenser l'aimantation longitudinale du bâtiment, d'autres 1b à compenser son aimantation verticale, d'autres 1c à compenser son aimantation transversale. Des courants électriques visant à minimiser au mieux la signature magnétique du bâtiment circulent dans ces boucles. Le bâtiment naval venant d'effectuer une opération de longue durée, sa signature magnétique s'est modifiée et la valeur des courants électriques circulant dans ses boucles d'immunisation doit être modifiée en conséquence.

Dans le but de procéder à cette opération, une station portable de mesures et de réglage de la signature magnétique du bâtiment naval 1 est déployée à proximité de celui-ci. Cette station de mesure portable comprend un chapelet déformable 2 constitué d'une gaine 3 à l'intérieur de laquelle sont disposés des magnétomètres 4. Ces magnétomètres 4 sont au nombre de cinq et sont disposés le long du chapelet 2 selon un espacement régulier de l'ordre des deux tiers de la hauteur d'eau. Par exemple pour des fonds de 20 m de profondeur, l'espacement est de 12 m. Dans ce cas, la longueur du chapelet est d'environ 48 m. Le chapelet déformable 2 est par ailleurs muni de capteurs de hauteur d'eau 12 constitués par des capteurs de pression en nombre égal au nombre de magnétomètres 4. Chaque capteur de pression 12 est positionné à proximité d'un magnétomètre 4.

A l'intérieur de la gaine 3, les différents capteurs, magnétomètres 4 et capteurs de pression 12, sont reliés entre eux par des câbles de reprise d'effort.

Le chapelet déformable 2 est par ailleurs muni à l'une de ses extrémités d'un lest 5 facilitant son déploiement. Ce chapelet déformable 2 est relié à une bouée de surface 6 par un câble 7 muni de moyens de lestage 8 constitués par une gueuse. La bouée 6 est par ailleurs munie de moyens de transmission 13 des données fournies par les magnétomètres 4 d'une part et par les capteurs de pression 12 d'autre part. Le bâtiment naval est équipé en conséquence de moyens de réception 14 de ces données. Le chapelet 2 est relié au câble 7, grâce à un cable de liaison 11, en un point de raccordement 9. La longueur du câble de liaison 11 est calculée en fonction de la profondeur de façon à permettre l'immersion de la gueuse 8 lorsque le chapelet 2 est presque totalement posé sur le fond de la mer.

Des moyens de largage 10 constitués par une manille explosive télécommandable sont positionnés entre la gueuse 8 et le point de raccordement 9.

Lors du déploiement de la station portable, le chapelet 2 est mis à l'eau grâce par exemple à un cannot. L'extrémité pourvue du lest 5 est immergée en premier de façon à permettre le déroulement du chapelet 2 et son positionnement progressif sur le fond.

Lorsque la gueuse 8 touche le fond de la mer, le câble 7, dont la longueur est prévue à cet effet, est tendu de façon à permettre une relative immobilité de la bouée 6 en surface.

Selon la figure 2, les magnétomètres 4 utilisés entrant dans la réalisation du chapelet déformable 2 sont des magnétomètres triaxiaux à vanne de flux pendulés sur deux axes.

Ce type de magnétomètre ne comporte qu'un seul noyau saturable par axe de mesure et est constitué d'une sonde verticale 20, d'une sonde transversale 21, et d'une sonde longitudinale 22. Chaque magnétomètre est placé dans un conte

neur 23 et est pendulé sur deux axes de manière à maintenir sa verticalité.

Le système de pendulage est obtenu en reliant le magnétomètre 4 à un axe transversal 24, le pendulage transversal du magnétomètre 4 étant autorisé grâce à un roulement à billes 25.

Le pendulage longitudinal du magnétomètre est obtenu en montant ledit axe longitudinal 24 sur deux balanciers 26 munis de roulements à billes 27. Les balanciers 26 sont eux-mêmes montés en rotation dans le conteneur 23 grâce à des roulements à billes 28.

Les données recueillies par les différentes sondes 20, 21, 22 du magnétomètre 4 sont transmises à un dispositif électronique 30 situé également à l'intérieur du conteneur 23 grâce à un collecteur tournant 29.

Tous les éléments constituant le chapelet déformable sont réalisés en des matériaux amagnétiques de façon à n'avoir aucune influence sur les paramètres relevés par les magnétomètres.

Pour interpréter correctement les données transmises par les magnétomètres 4 et les capteurs de pression 12 du chapelet 2, il est nécessaire de connaître la déformée du chapelet lorsque celui-ci est mouillé sur le fond.

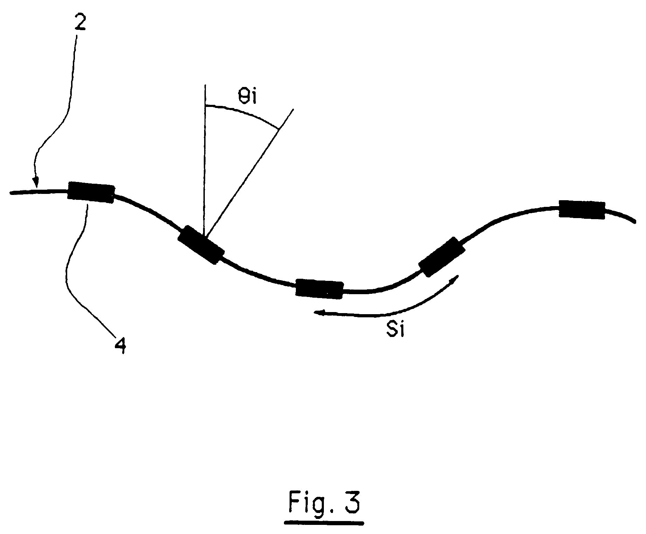

Selon la figure 3, le chapelet 2 repose sur le fond de la mer. Les cinq magnétomètres 4 sont séparés les uns des autres selon un espacement $S_i$ et forment des angles $\theta_i$ avec le nord magnétique.

La déformée du chapelet 2 dans le plan vertical est donnée directement par les capteurs de pression 12, la pression enregistrée par ceux-ci étant proportionnelle à la profondeur z à laquelle ils sont positionnés.

La déformée dans le plan horizontal est obtenue en utilisant une méthode d'interpolation, par exemple la méthode SPLINE, à l'aide des coordonnées curvilignes $S_i$ des magnétomètres et à l'aide des angles $\theta_i$ que ceux-ci forment avec le plan horizontal. Les angles $\theta_i$ sont obtenus à partir des composantes $H_x$ et $H_y$ du champ magnétique suivant la formule :

$$\theta_i = \text{arctg}\ \frac{H_x}{H_y}$$

Pour évaluer correctement ces angles $\theta_i$, le bâtiment naval est éloigné momentanément afin de n'avoir aucune influence sur les données fournies par les magnétomètres 4.

Lorsque la déformée du chapelet est déterminée, le positionnement du bâtiment naval par rapport au chapelet est évaluée grâce aux données z fournies par les capteurs de pression 12 en calculant la dérivée seconde

$$\frac{\delta^2 \, Bz}{\delta z^2}$$

du champ magnétique et en recherchant la courbe de niveau

$$\frac{\delta^2 Bz}{\delta z^2} = 0$$

Le positionnement du bâtiment est ensuite affinée grâce à une méthode de "tracking" utilisant des réflecteurs laser situés sur le bâtiment, un système terrestre permettant de localiser ces réflecteurs.

Lorsque la déformée du chapelet 2 et le positionnement du bâtiment 1 sont connus, la trajectoire du bâtiment est déterminée.

Les données fournies par les magnétomètres sont alors recueillies lors d'au moins un passage du bâtiment 1 selon la trajectoire déterminée. Ces données permettent d'évaluer la signature magnétique du bâtiment et éventuellement de modifier les courants circulant dans les boucles d'immunisation de façon à réajuster celle-ci.

Une fois l'opération terminée, l'explosion de la manille 10 peut être télécommandée de façon à provoquer le largage du chapelet 2. Celui-ci peut alors être récupéré grâce à la bouée 6.

## Revendications

1. Station portable de mesure et de réglage de la signature magnétique d'un bâtiment naval (1) destinée à déterminer les caractéristiques des courants à faire circuler dans les boucles d'immunisation magnétique (1c, 1b) dont est muni ledit bâtiment naval, du type comprenant un capteur magnétique (4) pouvant être déposé sur le fond de la mer et un capteur de hauteur d'eau (12) associé au capteur magnétique, ledit capteur magnétique étant constitué par un magnétomètre trixial pendulé sur deux axes et étant relié, ainsi que ledit capteur de hauteur d'eau, à des moyens de transmission (13) des données qu'ils fournissent, et ledit bâtiment naval étant muni de moyens de réception (14) desdites données, caractérisé en ce qu'il comprend un ensemble de capteurs magnétiques et un ensemble de capteurs de hauteur d'eau disposés à l'intérieur d'une gaine souple déformable pour former un chapelet déformable pouvant être déposé au fond de la mer.

2. Station portable selon la revendication 1 caractérisée en ce que lesdits capteurs de hauteur d'eau (12) sont constitués par des capteurs de pression.

3. Station selon la revendication 2, caractérisée en ce que le nombre de capteurs de hauteur d'eau (12) est égal au nombre de capteurs magnétiques (4).

4. Station selon l'une des revendications 1 à 3 caractérisée en ce que lesdits capteurs magnétiques (4) sont disposés dans ladite gaine (2) selon un espacement régulier.

5. Station portable selon la revendication 4 caractérisée en ce que ledit espacement correspond environ à la profondeur d'eau à laquelle ladite gaine (2) est susceptible d'être déposée.

6. Station portable selon l'une des revendications 1 à 5, caractérisée en ce que ledit chapelet (2) est relié à une bouée de surface (6) unique munie desdits moyens de transmission (13) des données fournies par les capteurs auxdits moyens de réception (14) desdites données situés sur ledit bâtiment naval (1).

7. Station portable selon la revendication 6 caractérisée en ce que ledit chapelet (2) est relié à ladite bouée (6) par un câble (7) muni de moyens de lestage (8), ledit chapelet (2) étant raccordé audit câble (7) en un point de raccordement (9) situé au-dessus des moyens de lestage (8), des moyens de largage (10) étant positionnés entre lesdits moyens de lestage (8) et ledit point de raccordement (9).

8. Station portable selon la revendication 7, caractérisée en ce que lesdits moyens de largage (10) sont télécommandables.

9. Station portable selon la revendication 8 caractérisée en ce que lesdits moyens de largage (10) télécommandables sont constitués par une manille explosive.

10. Station portable selon l'une des revendications 1 à 9, caractérisé en ce que le nombre de capteurs magnétiques (4) est au moins égal à cinq.

11. Station portable selon l'une des revendications 1 à 10, caractérisée en ce que ledit chapelet (2) comprend également des capteurs acoustiques.

**12.** Procédé de mesure et de réglage de la signature magnétique d'un bâtiment naval, pour la mise en oeuvre d'une station selon l'une quelconque des revendications 1 à 11 caractérisée en ce qu'il comprend les étapes consistant à :

- déployer ledit chapelet au fond de la mer;
- évaluer la déformée dudit chapelet de façon à connaître la position relative desdits capteurs magnétiques;
- déterminer le positionnement dudit bâtiment naval par rapport audit chapelet ;
- déterminer la trajectoire du bâtiment naval ;
- recueillir les données fournies par lesdits capteurs magnétiques dudit chapelet lors d'au moins un passage dudit bâtiment naval selon ladite trajectoire.

**13.** Procédé selon la revendication 12 caractérisé en ce que l'étape consistant à évaluer la déformée dudit chapelet consiste à :

- déterminer la déformée dudit chapelet dans le plan vertical en utilisant les données fournies par les capteurs de hauteur d'eau ;
- déterminer la déformée dudit chapelet dans le plan horizontal en utilisant une méthode d'interpolation mettant en oeuvre les coordonnées curvilignes Si des capteurs magnétiques d'une part et les angles les $\theta_i$ que ceux-ci forment avec le nord magnétique d'autre part.

**14.** Procédé selon la revendication 13 caractérisé en ce que les angles $\theta_i$ sont obtenus à partir des valeurs des composantes Hx, Hy du champ magnétique dans le plan horizontal selon la formule :

$$\theta_i = \text{arctg} \frac{Hx}{Hy}$$

le bâtiment naval étant suffisamment éloigné dudit chapelet pour ne pas avoir d'influence sur les valeurs des composantes Hx et Hy.

**15.** Procédé selon l'une des revendications 12 à 14, caractérisé en ce que l'étape consistant à déterminer le positionnement dudit bâtiment naval par rapport audit chapelet consiste notamment à calculer, à partir des données des capteurs de hauteurs d'eau la dérivée seconde du champ magnétique

$$\frac{\delta^2 Bz}{\delta z^2}$$

et à chercher la courbe de niveau

$$\frac{\delta^2 Bz}{\delta z^2} = 0$$

**16.** Procédé selon l'une des revendications 12 à 15, caractérisé en ce que l'étape consistant à déterminer le positionnement du bâtiment naval est affinée par une méthode de "tracking" magnétique, acoustique ou optique.

**17.** Procédé selon la revendication 16 caractérisé en ce que ladite méthode de tracking est réalisée en munissant le bâtiment de réflecteurs laser, un système terrestre permettant de localiser ces réflecteurs.

**Claims**

**1.** Portable station for measuring and adjusting the magnetic signature of a naval ship (1) and intended for determining the characteristics of the currents to be made to flow in the magnetic immunization loops (1c, 1b) with which the said naval ship is equipped, of the type comprising a magnetic sensor (4) capable of being laid on the bottom of the sea and a water-height sensor (12) associated with the magnetic sensor, the said magnetic sensor consisting of a triaxial magnetometer hung on two spindles and being connected, as is the said water-height sensor, to means (13) of relaying the data which they provide, and the said naval ship being equipped with means (14) of receiving the said data, characterized in that it comprises a set of magnetic sensors and a set of water-height sensors arranged inside a deformable flexible sheath to form a deformable string capable of being laid on the bottom of the sea.

**2.** Portable station according to Claim 1, characterized in that the said water-height sensors (12) consist of pressure sensors.

**3.** Station according to Claim 2, characterized in that the number of water-height sensors (12) is equal to the number of magnetic sensors (4).

4. Station according to one of Claims 1 to 3, characterized in that the said magnetic sensors (4) are arranged in the said sheath (2) according to a regular spacing.

5. Portable station according to Claim 4, characterized in that the said spacing corresponds roughly to the water depth at which the said sheath (2) is liable to be laid.

6. Portable station according to one of Claims 1 to 5, characterized in that the said string (2) is connected to a single surface buoy (6) fitted with the said means (13) of relaying the data provided by the sensors to the said means (14) of receiving the said data, situated on the said naval ship (1).

7. Portable station according to Claim 6, characterized in that the said string (2) is connected to the said buoy (6) by a cable (7) equipped with ballast means (8), the said string (2) being joined to the said cable (7) at a junction point (9) situated above the ballast means (8), casting-off means (10) being positioned between the said ballast means (8) and the said junction point (9).

8. Portable station according to Claim 7, characterized in that the said casting-off means (10) are remotely controllable.

9. Portable station according to Claim 8, characterized in that the said remotely controllable casting-off means (10) consist of an explosive shackle.

10. Portable station according to one of Claims 1 to 9, characterized in that the number of magnetic sensors (4) is equal to at least five.

11. Portable station according to one of Claims 1 to 10, characterized in that the said string (2) also comprises acoustic sensors.

12. Process for measuring and adjusting the magnetic signature of a naval ship, for the implementation of a station according to any one of Claims 1 to 11, characterized in that it comprises the steps consisting in:
   - deploying the said string on the bottom of the sea;
   - evaluating the deflection of the said string so as to ascertain the relative position of the said magnetic sensors;
   - determining the positioning of the said naval ship with respect to the said string;
   - determining the path of the naval ship;
   - gathering the data provided by the said magnetic sensors of the said string during at least one pass of the said naval ship along the said path.

13. Process according to Claim 12, characterized in that the step consisting in evaluating the deflection of the said string consists in:
   - determining the deflection of the said string in the vertical plane by using the data provided by the water-height sensors;
   - determining the deflection of the said string in the horizontal plane by using a method of interpolation employing the curvilinear coordinates Si of the magnetic sensors on the one hand and the angles $\theta i$ which the latter make with magnetic north on the other hand.

14. Process according to Claim 13, characterized in that angles $\theta i$ are obtained from the values of the components Hx, Hy of the magnetic field in the horizontal plane through the formula:

$$\theta i = \arctan \frac{Hx}{Hy}$$

the naval ship being retreated sufficiently far from the said string as to not have any influence on the values of the components Hx and Hy.

15. Process according to one of Claims 12 to 14, characterized in that the step consisting in determining the positioning of the said naval ship relative to the said string consists in particular in calculating, based on the data from the water-height sensors, the second derivative of the magnetic field

$$\frac{\delta^2 Bz}{\delta z^2}$$

and in searching for the level curve

$$\frac{\delta^2 Bz}{\delta z^2} = 0$$

16. Process according to one of Claims 12 to 15, characterized in that the step consisting in determining the positioning of the naval ship is refined by a method of magnetic, acoustic or optical "tracking".

17. Process according to Claim 16, characterized in that the said method of tracking is carried out by equipping the ship with laser reflectors, a land-based system enabling these reflectors to be pinpointed.

**Patentansprüche**

1. Tragabare Station zum Messen und Einstellen der magnetischen Signatur eines Wasserfahrzeugs (1) für die Bestimmung der Kenngrößen von in den magnetischen Immunisierungsschleifen (1c, 1b), mit denen das Schiff ausgestattet ist, zu erzeugenden Strömen, vom Typ mit einem am Meeresboden anzubringenden Magnetaufnehmer (4) und einem dem Magnetaufnehmer immer zugeordneten Wassertiefenaufnehmer (12), wobei der Magnetaufnehmer von einem an zwei Achsen aufgehängten dreiachsigen Magnetometer gebildet ist und ebenso wie der Wassertiefenaufnehmer an Mittel (13) zum Übertragen von von ihnen gelieferten Daten angeschlossen ist, und wobei das Wasserfahrzeug mit Empfangsmitteln (14) für diese Daten ausgestattet ist, dadurch gekennzeichnet, daß sie eine Gruppe von Magnetaufnehmern und eine Gruppe von Wassertiefenaufnehmern enthält, die im Inneren eines biegsamen Mantels angeordnet sind, der zur Bildung einer verformbaren Perlenschnur verformbar ist, die am Meeresboden angebracht werden kann.

2. Tragbare Station nach Anspruch 1, dadurch gekennzeichnet, daß die Wassertiefenaufnehmer (12) von Druckaufnehmern gebildet sind.

3. Station nach Anspruch 2, dadurch gekennzeichnet, daß die Anzahl der Wassertiefenaufnehmer (12) gleich der Anzahl der Magnetaufnehmer (4) ist.

4. Station nach einem der Ansprüche 1 bis 3, dadurch gekennzeichnet, daß die Magnetaufnehmer (4) in dem Mantel (2) in regelmäßigem Abstand angeordnet sind.

5. Tragbare Station nach Anspruch 4, dadurch gekennzeichnet, daß der Abstand etwa der Wassertiefe entspricht, in der der Mantel (2) angebracht werden kann.

6. Tragbare Station nach einem der Ansprüche 1 bis 5, dadurch gekennzeichnet, daß die Perlenschnur (2) mit einer einzigen Oberflächenboje (6) verbunden ist, die mit den Mitteln (13) zum Übertragen von Daten versehen ist, die von den Aufnehmern an die Datenempfangsmittel (14) geliefert werden, die auf dem Wasserfahrzeug (1) angebracht sind.

7. Tragbare Station nach Anspruch 6, dadurch gekennzeichnet, daß die Perlenschnur (2) mit der Boje (6) über ein Kabel (7) verbunden ist, das mit Ballastmitteln (8) ausgestattet ist, wobei die Perlenschnur (2) an einem Anschlußpunkt (9) an das Kabel (7) angeschlossen ist, der oberhalb der Ballastmittel (2) liegt, wobei zwischen den Ballastmitteln (8) und dem Anschlußpunkt (9) Abtrennmittel (10) angebracht sind.

8. Tragbare Station nach Anspruch 7, dadurch gekennzeichnet, daß die Abtrennmittel (10) fernsteuerbar sind.

9. Tragbare Station nach Anspruch 8, dadurch gekennzeichnet, daß die fernsteuerbaren Abtrennmittel (10) von einem Sprengschäkel gebildet sind.

10. Tragbare Station nach einem der Ansprüche 1 bis 9, dadurch gekennzeichnet, daß die Anzahl der Magnetaufnehmer (4) wenigstens gleich fünf ist.

11. Tragbare Station nach einem der Ansprüche 1 bis 10, dadurch gekennzeichnet, daß die Perlenschnur (2) auch Schallaufnehmer enthält.

12. Verfahren zum Messen und Einstellen der magnetischen Signatur eines Wasserfahrzeugs für die Verwirklichung einer Station gemäß einem der Ansprüche 1 bis 11, dadurch gekennzeichnet, daß es Stufen enthält, die darin bestehen, daß:
    - die Perlenschnur am Meeresboden ausgelegt wird;
    - die Biegelinie der Perlenschnur ausgewertet wird, um die relative Position der Magnetaufnehmer in Erfahrung zu bringen;
    - die Position des Wasserfahrzeugs bezüglich der Perlenschnur bestimmt wird;
    - die Bahn des Wasserfahrzeugs bestimmt wird;
    - die von den Magnetaufnehmern der Perlenschnur gelieferten Daten während wenigstens eines Durchgangs des Wasserfahrzeugs längs der Bahn erfaßt werden.

**13.** Verfahren nach Anspruch 12, dadurch gekennzeichnet, daß die Stufe zur Auswertung der Wegelinie der Perlenschnur darin besteht, daß:

- die Biegelinie der Perlenschnur in der Vertikalebene unter Verwendung der von den Wassertiefenaufnehmern gelieferten Daten bestimmt wird;
- die Biegelinie der Perlenschnur in der Horizontalebene mittels Anwendung eines Interpolationsverfahrens bestimmt wird, bei dem einerseits von den Krümmungskoordinaten Si der Magnetaufnehmer und andererseits den Winkeln $\theta i$, die diese mit der magnetischen Nordrichtung bilden, Gebrauch gemacht wird.

**14.** Verfahren nach Anspruch 13, dadurch gekennzeichnet, daß die Winkel $\theta i$ mittels der Werte der Komponenten Hx, Hy des Magnetfeldes in der Horizontalebene gemäß der Formel:

$$\theta i = \operatorname{arctg} \frac{Hx}{Hy}$$

erhalten werden, wobei das Wasserfahrzeug genügend weit von der Perlenschnur entfernt ist, damit kein Einfluß auf die Werte der Komponenten Hx und Hy vorliegt.

**15.** Verfahren nach einem der Ansprüche 12 bis 14, dadurch gekennzeichnet, daß die Stufe zur Bestimmung der Position des Wasserfahrzeugs bezüglich der Perlenschnur insbesondere darin besteht, daß mittels der Daten der Wassertiefenaufnehmer die zweite Ableitung des Magnetfeldes

$$\frac{\delta^2 \; Bz}{\delta \; z^2}$$

gebildet wird, und das die folgende Höhenkurve gesucht wird:

$$\frac{\delta^2 Bz}{\delta \; z^2} = 0$$

**16.** Verfahren nach einem der Ansprüche 12 bis 15, dadurch gekennzeichnet, daß die Stufe zur Bestimmung der Position des Wasserfahrzeugs mit Hilfe eines magnetischen, akustischen oder optischen "Nachführungs"-Verfahrens verfeinert wird.

**17.** Verfahren nach Anspruch 16, dadurch gekennzeichnet, daß das Nachführungs-Verfahren dadurch realisiert wird, daß das Wasserfahrzeug mit Laserreflektoren ausgestattet wird, wobei ein terrestrisches System die Ortung dieser Reflektoren ermöglicht.

Fig. 1

Fig. 2

Fig. 3